(19) **Europäisches Patentamt**

**European Patent Office**

**Office européen des brevets**

(11) **EP 0 543 907 B1**

(12) **EUROPEAN PATENT SPECIFICATION**

(45) Date of publication and mention
of the grant of the patent:
**23.04.1997  Bulletin 1997/17**

(21) Application number: **91915279.3**

(22) Date of filing: **05.08.1991**

(51) Int Cl.⁶: **H04L 1/00**

(86) International application number:
**PCT/SE91/00519**

(87) International publication number:
**WO 92/03879 (05.03.1992 Gazette 1992/06)**

(54) **METHOD OF RECOVERING LOST BITS IN DIGITAL TRANSMISSION**

VERFAHREN ZUR RÜCKGEWINNUNG VERLORENER BITS IN DIGITALER ÜBERTRAGUNG

PROCEDE DE RECUPERATION DE BITS PERDUS LORS DE LA TRANSMISSION NUMERIQUE

(84) Designated Contracting States:
**BE CH DE FR GB LI NL**

(30) Priority: **15.08.1990  SE 9002646**

(43) Date of publication of application:
**02.06.1993  Bulletin 1993/22**

(73) Proprietor: **TELIA AB**
**123 86 Farsta (SE)**

(72) Inventor: **BRUSEWITZ, Harald**
**S-123 86 Farsta (SE)**

(74) Representative: **Karlsson, Berne et al**
**Telia Research AB,**
**Koncernpatent**
**136 80 Haninge (SE)**

(56) References cited:
**EP-A- 0 154 538          EP-A- 0 397 385**
**US-A- 4 476 562**

**Description**

FIELD OF THE INVENTION

The present invention relates to a method of recovering lost bits in accordance with the preamble of claim 1.

STATE OF THE ART

For a block of n data bits k control bits are calculated, whereafter the n+k bits are transmitted. In the transmission some bits may be lost. According to the state of the art the lost bits are replaced by dummy bits which then are corrected with a conventional error correction code. The knowledge about the positions of the lost bits is not used, whereby unnecessarily many control bits have to be calculated and transmitted. In addition the error correction is often a complex method.

Document US-A-4 476 562 discloses a method for detecting and correcting errors in received digital data signals comprising the steps of generating a plurality of signals representative of error syndrome words by multiplying a block of received data signals with a parity check matrix; determining whether errors exist in said received digital data signals by checking preselected equalities or inequalities among said generated signals; and generating error pattern signals using said signals representative of error syndrome words for locating any indicated errors in response to said indication signals representative of the existence of errors; and correcting located errors in the received digital data signals using said generated error pattern signals.

In contrast, the present invention utilizes the knowledge about the positions of the lost cells in ATM-networks. Thus, the number of control bits can be reduced and a simpler method of recovering the lost bits is obtained.

SUMMARY OF THE INVENTION

Thus, the present invention provides a method of recovering lost bits in packet transmission in ATM networks in accordance with the characterizing portion of claim 1.

Further features of the invention are set forth in the accompanying claims.

DETAILED DESCRIPTION OF THE PREFERRED EMBODIMENTS OF THE INVENTION

The present invention may be classified among systems with "soft decoding". In a so-called soft decoding, in the first step, a decision is taken whether a recieved bit belongs to some of the following categories:

a) the recieved bit is definitely a zero,
b) the recieved bit.is definitely a one,
c) uncertain which value the bit is.

In applying the invention the case c) is instead defined as "lost bit". Since its position is known this information should be utilized. For each bit to be recovered at least one control bit is required. The control bits are calculated by fulfilling parity relations calculated from the data bits and a number of fixed parity constants. The parity constans should be chosen such that maximal information is obtained about the data bits. The parity constans depend on the number of control bits.

| The n data bits are denoted | d1, d2, ... dn. |
|---|---|
| The k control bits are denoted | c1, c2, ... ck. |
| The parity constants are denoted | p11, p12, ... p1n |
| | p21, p22, ... p2n |
| | . |
| | . |
| | pk1, pk2, ... pkn. |

The control bits are calculated in the transmitter using the following equation

$$ci = pi1.d1 + pi2.d2 + ... + pin.dn \qquad (1)$$

The equation is a rearrangement of the following parity relation (i=1...k)

$$0 = c_i + p_{i1}.d_1 + p_{i2}.d_2 + ... + p_{in}.d_n \qquad (2)$$

"." refers to binary multiplication (AND) that is

a.b=0 if a=0 or b=0
a.b=1 if a=1 and b=1

"+" refers to addition modulo 2 (EXOR), that is the result is

0 if an even number of ones is included in the sum and
1 if an odd number of ones is included in the sum.

Lost bits are recovered in the receiver in the following way. Syndrome bits $s_i$ are calculated for i=1...k with the formula

$$s_i = c_i' + p_{i1}.d_1' + p_{i2}.d_2' + ... + p_{in}.d_n' \qquad (3)$$

The symbol ' refers to lost bits being replaced by zeros in the calculation. With knowledge about the positions about the lost bits and the values of the syndrome bits $s_i$ the values of the lost bits can be calculated.

A lost bit in position u may only be recovered if $p_{iu}=1$ for at least one value of i. It is suitable and possible to choose a parity constant in such a way. However, there are restrictions on the positions and number of lost bits which may be recovered.

## Example 1

k=1, that is one control bit is used. In this case, only one lost bit can be recovered. It is suitable that $p_{1j}=1$ for every j. If $s_1=1$ the lost bit is one. If $s_1=0$ the lost bit is a zero. If no bit is lost $s_1=0$ always (if an odd number of transmission errors has occured).

## Example 2

k=2, that is two control bits are used. In this case one, and in certain cases two, lost bits may be recovered.

A lost bit can always be recovered in position u if $p_{1u}=1$ or $p_{2u}=1$, similarly as example 1. If the lost bit is a control bit no step need be taken in the receiver.

Two lost bits may be recovered in the positions u and v if the parity constants fulfill any of the conditions a-b.

```
a.  p1u p1v = 1 1   →   (s1,s2) = (0,0) → (du,dv) = (0,0)
    p2u p2v = 1 0       (s1,s2) = (0,1) → (du,dv) = (1,1)


                        (s1,s2) = (1,0) → (du,dv) = (0,1)
                        (s1,s2) = (1,1) → (du,dv) = (1,0)


b.  p1u p1v = 1 0   →   (s1,s2) = (0,0) → (du,dv) = (0,0)
    p2u p2v = 0 1       (s1,s2) = (0,1) → (du,dv) = (0,1)
                        (s1,s2) = (1,0) → (du,dv) = (1,0)
                        (s1,s2) = (1,1) → (du,dv) = (1,1)
```

Note that the cases a-b are more general than they seem to be, in that u and v, and c1 and c2, respectively, may change positions. Thus, the following cases work as well.

```
p1u p1v        =        1 1    0 1    1 0
p2u p2v        =        0 1    1 1    1 1


p1u p1v        =        0 1
p2u p2v        =        1 0
```

Two lost bits can not be recovered in the positions u and v, if the parity constants have values according to c.

```
c. p1u p1v     =     0 0    0 1    1 1    1 0    1 1
   p2u p2v     =     0 0    0 0    0 0    1 0    1 1
```

Three lost bits can never be recovered using two parity bits.

If one of the lost bits is a control bit the lost bit can be recovered as in example one. If both the lost bits are control bits no step need be taken in the receiver.

Examples are given below of choice of parity constants and their capacity of recovering lost bits

```
p11,12,13, ...= 1 1 0 1 1 0 1 1 0 1 1 0 1 1 0 1 1 0 1 1 0...
p21,22,23, ...= 0 1 1 0 1 1 0 1 1 0 1 1 0 1 1 0 1 1 0 1 1...
```

Single losses:     All
Double losses:     Two thirds, for instance adjacent, does not work if ci does not depend on the lost bit/bits
Triple losses:     None

Example 3

k=3, that is three control bits are used.

One lost bit can be recovered in position u if it is not true that p1u=p2u=p3u=0.

Two lost bits can be recovered in positions u and v if (p1u,p1v,p2u,p2v) or (p1u,p1v,p3u,p3v) or (p2u,p2v,p3u,p3v) fulfill any of the conditions a-b in example 2.

Three lost bits can be recovered in the positions u,v and w if

a.(p1u,p1v,p1w) = 1 1 1 →
(p2u,p2v,p2w) = 1 1 0
(p3u,p3v,p3w) = 0 1 1

(s1,s2,s3)=(0,0,0) → (du,dv,dw)=(0,0,0)
(s1,s2,s3)=(0,0,1) → (du,dv,dw)=(1,1,0)
(s1,s2,s3)=(0,1,0) → (du,dv,dw)=(0,1,1)
(s1,s2,s3)=(1,0,0) → (du,dv,dw)=(1,1,1)
(s1,s2,s3)=(0,1,1) → (du,dv,dw)=(1,0,1)
(s1,s2,s3)=(1,0,1) → (du,dv,dw)=(0,0,1)
(s1,s2,s3)=(1,1,0) → (du,dv,dw)=(1,0,0)
(s1,s2,s3)=(1,1,1) → (du,dv,dw)=(0,1,0)

b.(p1u,p1v,p1w) = 0 1 0 →
(p2u,p2v,p2w) = 1 0 1
(p3u,p3v,p3w) = 1 1 0

(s1,s2,s3)=(0,0,0) → (du,dv,dw)=(0,0,0)
(s1,s2,s3)=(0,0,1) → (du,dv,dw)=(1,0,1)
(s1,s2,s3)=(0,1,0) → (du,dv,dw)=(0,0,1)
(s1,s2,s3)=(1,0,0) → (du,dv,dw)=(1,1,1)
(s1,s2,s3)=(0,1,1) → (du,dv,dw)=(1,0,0)
(s1,s2,s3)=(1,0,1) → (du,dv,dw)=(0,1,0)
(s1,s2,s3)=(1,1,0) → (du,dv,dw)=(1,1,0)
(s1,s2,s3)=(1,1,1) → (du,dv,dw)=(0,1,1)

Other combinations, based on the two above, in which three losses can be recovered are

```
1 1 1    1 1 1    1 1 1    1 1 1    1 1 1    1 1 1
1 0 1    0 1 1    1 1 0    0 1 1    1 0 1    1 1 0
0 1 1    1 0 1    0 1 1    1 1 0    1 1 0    1 0 1
```

```
1 0 1    0 1 1    1 1 0    0 1 1    1 0 1    1 1 0
1 1 1    1 1 1    1 1 1    1 1 1    1 1 1    1 1 1
0 1 1    1 0 1    0 1 1    1 1 0    1 1 0    1 0 1


1 0 1    0 1 1    1 1 0    0 1 1    1 0 1    1 1 0
0 1 1    1 0 1    0 1 1    1 1 0    1 1 0    1 0 1
1 1 1    1 1 1    1 1 1    1 1 1    1 1 1    1 1 1


0 1 0    0 0 1    1 0 0    1 0 0    0 0 1    0 1 0
1 0 1    1 1 0    0 1 1    0 1 1    1 1 0    1 0 1
1 1 0    1 0 1    1 1 0    1 0 1    0 1 1    0 1 1


1 0 1    1 1 0    0 1 1    0 1 1    1 1 0    1 0 1
0 1 0    0 0 1    1 0 0    1 0 0    0 0 1    0 1 0
1 1 0    1 0 1    1 1 0    1 0 1    0 1 1    0 1 1


1 1 0    1 0 1    1 1 0    1 0 1    0 1 1    0 1 1
0 1 0    0 0 1    1 0 0    1 0 0    0 0 1    0 1 0
```

Three losses cannot be recovered in the positions u, v and w if

$$(p1u, p1v, p1w) = 1\ 0\ 1$$
$$(p2u, p2v, p2w) = 1\ 1\ 0$$
$$(p3u, p3v, p3w) = 0\ 1\ 1$$

Examples are given below of choice of parity constants and their respective capacity of recovering lost bits.

```
p11,p12,p13,...=1 1 1 1 1 1 1 1 1 1 1 1 1 1 1 1 1 1 ....
p21,p22,p23,...=1 1 0 1 1 0 1 1 0 1 1 0 1 1 0 1 1 0 ....
p31,p32,p33,...=0 1 1 0 1 1 0 1 1 0 1 1 0 1 1 0 1 1 ....
```

Single losses:      All
Double losses:      Two thirds, for instance two adjacent
Triple losses:      One third, for instance three adjacent

```
p11,p12,p13,...=1 1 1 0 1 1 1 0 1 1 1 0 1 1 1 0 1 1 1 0 ....
p21,p22,p23,...=1 1 0 1 1 1 0 1 1 1 0 1 1 1 0 1 1 1 0 1 ....
p31,p32,p33,...=0 1 1 1 0 1 1 1 0 1 1 1 0 1 1 1 0 1 1 1 ....
```

Single losses:      All
Double losses:      Three fourths, for instance two adjacent

6

Triple losses: 9/32, for instance 3/4 of all adjacent

Example of application - Cell loss in ATM networks

In packet transmission in ATM-networks so-called 'cells' are transmitted, consisting of a heading (not dealt with here) and a data field consisting of 384 bits. According to a decision of ETSI-NA5 four of these data bits are a 'cell number' that can assume values between 0 and 15. If the receiver detects that a cell number is missing, the cell having this number is lost in the transmission. Thereby the position of the cell is known. By letting one or more cells be'control cells' lost cells can be recovered using the technique of the invention. The technique of the invention is thereby applied "across" cells, illustrated by an example (k=1) in the table below.

| 4 bits | 380 bits | |
|--------|----------|--------|
| no=0 | data bits | d0 |
| no=1 | data bits | d1 |
| no=2 | data bits | d2 |
| no=3 | data bits | d3 |
| no=4 | data bits | d4 |
| no=5 | data bits | d5 |
| no=6 | data bits | d6 |
| | lost cell | x=d7' |
| no=8 | data bits | d8 |
| no=9 | data bits | d9 |
| no=10 | data bits | d1 |
| no=11 | data bits | d1 |
| no=12 | data bits | d1 |
| no=13 | data bits | d1 |
| no 14 | data bits | d1 |
| no=15 | control bits | c1 |

Using the control bit cl and data bits d0-d6 and d8-d14 the lost bit x=d7' can be recovered. The same technique is used for all the 380 data bits. The cell number is not replaced by control bits.

Thus, the present invention provides an efficient method of recovery in lost data bits in digital transmission. Using the present description, a person skilled in the art can realize the invention by means of existing components and equipment. In a preferred embodiment the syndrome bits are mapped on the data bits in accordance with the tables above by reading in a look-up table in the receiver, but other ways are also possible. The invention is only limited by the accompanying claims.

**Claims**

1. Method of recovering lost packets in packet transmission in ATM networks from a transmitter to a receiver, wherein the transmitter performs error correction for recovering lost bits, a number of data bits (d1...dn), that represent the information that is to be transmitted, being transmitted together with a number of control bits (c1...ck), the bits being sent divided into cells, which begin with a bit string indicating cell number, followed by data bits (d1...dn) for data cells and control bits (c1...ck) for control cells, respectively, comprising the steps of:

   calculating the control bits in the transmitter using a number of parity constants (p11...pkn) so that the corresponding number of parity relations are fulfilled;
   detecting the positions of the lost bits in the receiver;
   calculating a number of syndrome bits (s1...sk) from the transmitted data bits and control bits; and

recovering the lost bits by mapping the syndrome bits (s1...sk) indicating the values of the lost bits, so that no information is lost in spite of the bits lost during the transmission, **characterized** in that the positions of the lost bits are detected by the receiver noting that one or several cell numbers are missing, whereupon the corresponding data bits are considered lost, and that the syndrome bits are mapped on the data bits using a look-up table in the receiver.

2. Method according to claim 1, **characterized** in that

the control bits are calculated as

$$c_i = p_{i1}.d_1 + p_{i2}.d_2 + ... + p_{in}.d_n$$

and
the syndrome bits are calculated as

$$s_i = c_{i1} + p_{i1}.d_1' + p_{i2}.d_2' + ... + p_{in}.d_n'$$

the prime symbol denoting that a lost bit is replaced by zero.

3. Method according to claim 2, **characterized** in that

the number of control bits k=1 and
the parity constants $p_{11} = p_{12} = ... = p_{in} = 1$.

4. Method according to claim 2, **characterized** in that

the number of control bits k = 2 and
the parity constants

```
p11, p12, p13,... = 1 1 0 1 1 0 1 1 0 ...
p21, p22, p23,... = 0 1 1 0 1 1 0 1 1 ...
```

5. Method according to claim 2, **characterized** in that a number of control bits k = 3 and
the parity constants

```
p11, p12, p13,... = 1 1 1 1 1 1 1 ...
p21, p22, p23,... = 1 1 0 1 1 0 1 ...
p31, p32, p33,... = 0 1 1 0 1 1 0 ...
```

6. Method according to claim 2, **characterized** in that the number of control bits k = 3 and
the parity constants

```
p11, p12, p13,... = 1 1 1 0 1 1 1 0 1 1 1 0 ...
p21, p22, p23,... = 1 1 0 1 1 1 0 1 1 1 0 1 ...
p31, p32, p33,... = 0 1 1 1 0 1 1 1 0 1 1 1 ...
```

**Patentansprüche**

1. Verfahren zum Wiedergewinnen von verlorenen Paketen bei der Paketübertragung in ATM-Netzwerken von einem Sender zu einem Empfänger, wobei der Sender Fehlerkorrektur zum Wiedergewinnen von verlorenen Bits durchführt, eine Anzahl von Datenbits (d1,..., dn), die die Information darstellen, die übertragen werden soll, zusammen mit einer Anzahl von Kontrollbits (c1,..., ck) übertragen wird, wobei die Bits in Zellen aufgeteilt gesendet werden, die mit einem Bitstrang beginnen, der die Zellennummer anzeigt, gefolgt von Datenbits (d1,..., dn) für Datenzellen und Kontrollbits (c1,..., ck) für Kontrollzellen, das die Schritte aufweist:

   die Steuerbits im Sender unter Verwendung einer Anzahl von Paritätskonstanten (p11,..., pkn) zu berechnen, so daß die entsprechende Anzahl von Paritätsbeziehungen erfüllt wird;

   die Positionen der verlorenen Bits im Empfänger festzustellen;

   eine Anzahl von Syndrombits (s1, ..., sk) aus den übertragenen Datenbits und Steuerbits zu berechnen; und

   die verlorenen Bits durch Abbilden der Syndrombits (s1, ..., sk), die die Werte der verlorenen Bits anzeigen, wiederzugewinnen, so daß keine Information trotz der Tatsache verloren wird, daß Bits während der Übertragung verloren worden sind, dadurch gekennzeichnet, daß die Positionen der verlorenen Bits durch den Empfänger detektiert werden, der feststellt, daß eine oder mehrere Zellennummern fehlen, woraufhin die entsprechenden Datenbits als verloren betrachtet werden, und daß die Syndrombits auf die Datenbits unter Verwendung einer Suchtabelle im Empfänger abgebildet werden.

2. Verfahren nach Anspruch 1, dadurch gekennzeichnet, daß die Kontrollbits berechnet werden als

   $$ci = pi1.d1 + pi2.d2 + ... + pin.dn$$

   und
   die Syndrombits berechnet werden als

   $$si = ci1 + pi1.d1' + pi2.d2' + ... + pin.dn',$$

   wobei das Apostroph-Zeichen anzeigt, daß ein verlorener Bit durch Null ersetzt ist.

3. Verfahren nach Anspruch 2, dadurch gekennzeichnet, daß die Anzahl der Kontrollbits k = 1 ist und die Paritätskonstanten p11 = p12 = ... = p1n = 1 sind.

4. Verfahren nach Anspruch 2, dadurch gekennzeichnet, daß die Anzahl der Kontrollbits k = 2 ist und die Paritätskonstanten

   **p11, p12, p13, ... = 1 1 0 1 1 0 1 1 0 ...**

   **p21, p22, p23, ... = 0 1 1 0 1 1 0 1 1 ...**

   sind.

5. Verfahren nach Anspruch 2, dadurch gekennzeichnet, daß die Anzahl der Kontrollbits k = 3 ist und die Paritätskonstanten

   **p11, p12, p13, ... = 1 1 1 1 1 1 1 ...**

   **p21, p22, p23, ... = 1 1 0 1 1 0 1 ...**

   **p31, p32, p33, ... = 0 1 1 0 1 1 0 ...**

sind.

6. Verfahren nach Anspruch 2, dadurch gekennzeichnet, daß die Anzahl der Kontrollbits k = 3 ist und die Paritäts-konstanten

$$p11, p12, p13, \dots = 1\ 1\ 1\ 0\ 1\ 1\ 1\ 0\ 1\ 1\ 1\ 0\ \dots$$

$$p21, p22, p23, \dots = 1\ 1\ 0\ 1\ 1\ 1\ 0\ 1\ 1\ 1\ 0\ 1\ \dots$$

$$p31, p32, p33, \dots = 0\ 1\ 1\ 1\ 0\ 1\ 1\ 1\ 0\ 1\ 1\ 1\ \dots$$

sind.

**Revendications**

1. Procédé de récupération des paquets perdus en transmission de paquets dans des réseaux ATM entre un émetteur et un récepteur, dans lequel l'émetteur exécute une correction d'erreur pour récupérer les bits perdus, un certain nombre de bits de données (d1...dn) qui représentent les informations à transmettre étant transmis en association avec un certain nombre de bits de commande (c1...ck), les bits étant envoyés divisés en cellules qui commencent par une chaîne de bits indiquant un numéro de cellule, suivis par des bits de données (d1...dn) pour les cellules de données ou par des bits de commande (c1...ck) pour les cellules de commande, respectivement, comprenant les étapes de :

   calcul des bits de commande dans l'émetteur au moyen d'un certain nombre de constantes de parité (p11... pkn) de façon à respecter le nombre correspondant de relations de parité ;
   détection des positions des bits perdus dans le récepteur ;
   calcul d'un certain nombre de bits de syndrome (s1...sk) à partir des bits de données et des bits de commande transmis ; et
   récupération des bits perdus, par mappage des bits de syndrome (s1...sk) indiquant les valeurs des bits perdus, de sorte qu'aucune information n'est perdue malgré la perte des bits pendant la transmission,

   caractérisé en ce que

   les positions des bits perdus sont détectées par le récepteur qui note qu'un ou plusieurs numéros de celulle sont manquants , après quoi les bits de données correspondants-sont considérés comme perdus, et
   les bits de syndrome sont mappés sur les bits de données au moyen d'une table de consultation dans le récepteur.

2. Procédé suivant la revendication 1, caractérisé en ce que :
   les bits de commande sont calculés comme suit

   $$ci = pi1.d1 + pi2.d2 + \dots + pin.dn$$

   et
   les bits de syndrome sont calculés comme suit

   $$si = ci1 + pi1.d1' + pi2.d2' + \dots + pin.dn'$$

   le symbole prime indiquant qu'un bit perdu est remplacé par zéro.

3. Procédé suivant la revendication 2, caractérisé en ce que le nombre de bits de commande k=1 et les constantes de parité p11=p12=...=p1n=1.

4. Procédé suivant la revendication 2, caractérisé en ce que le nombre de bits de commande k=2 et les constantes

de parité

```
p11, p12, p13,... = 1 1 0 1 1 0 1 1 0 ..
p21, p22, p23,... = 0 1 1 0 1 1 0 1 1 ..
```

5. Procédé suivant la revendication 2, caractérisé en ce que le nombre de bits de commande k=3 et les constantes de parité

```
p11, p12, p13,... = 1 1 1 1 1 1 1 ...
p21, p22, p23,... = 1 1 0 1 1 0 1 ...
p31, p32, p33,... = 0 1 1 0 1 1 0 ...
```

6. Procédé suivant la revendication 2, caractérisé en ce que le nombre de bits de commande k=3 et les constantes de parité

```
p11, p12, p13,... = 1 1 1 0 1 1 1 0 1 1 1 0 ...
p21, p22, p23,... = 1 1 0 1 1 1 0 1 1 1 0 1 ...
p31, p32, p33,... = 0 1 1 1 0 1 1 1 0 1 1 1 ...
```